Europäisches Patentamt

European Patent Office

Office européen des brevets

(11) Publication number: **0 418 427 A2**

# EUROPEAN PATENT APPLICATION

(21) Application number: 89123392.6

(22) Date of filing: 18.12.89

(51) Int. Cl.⁵: **G03F 7/20, H05K 3/00**

(30) Priority: 06.09.89 JP 232166/89
14.11.89 JP 296940/89

(43) Date of publication of application:
27.03.91 Bulletin 91/13

(84) Designated Contracting States:
DE FR GB IT NL SE

(71) Applicant: Miyake, Eiichi
D3-304, 7 Shinsenriminami-machi 3-chome
Toyonaka-shi Osaka(JP)

(72) Inventor: Miyake, Eiichi
D3-304, 7 Shinsenriminami-machi 3-chome
Toyonaka-shi Osaka(JP)

(74) Representative: Kirschner, Klaus Dieter et al
Patentanwälte Herrmann-Trentepohl
Kirschner Grosse Bockhorni Forstenrieder
Allee 59
W-8000 München 71(DE)

(54) Exposure process.

(57) A photomask is made in contact with or approach a board to which a photosensitive material for a printed circuit is applied, and a clearance between the photomask and the board is filled up with a liquid such as water. The liquid, which has smaller difference in refractive index between the same and the photomask and the photosensitive material as compared with air, facilitates linearity of light. Thus, a pattern provided on the photomask can be reproduced on the photosensitive material, i.e., the board, in high fidelity.

*FIG. 1*

## EXPOSURE PROCESS

### BACKGROUND OF THE INVENTION

#### Field of the Invention

The present invention relates to an exposure process which is employed for forming a circuit on a printed circuit board, for example.

#### Description of the Background Art

Fig. 5 shows a conventional exposure process, which is adapted to form a circuit on a printed circuit board 1.

As shown in Fig. 5, a photomask 3 which is provided with a pattern 2 corresponding to the circuit is horizontally arranged, for example. On the other hand, the printed circuit board 1 is previously provided with a photosensitive material 4, which is in the form of a film. This photosensitive film 4 can be formed by adhering a photosensitive dry film onto the board 1 or applying a paste or liquid material for forming the photosensitive film 4 to the board 1. The printed circuit board 1 is arranged on the photomask 3 so that its surface provided with the photosensitive film 4 faces the photomask 3. In this state, the board 1 is covered with a thin cover film 5, whose outer peripheral portion is completely sealed against the photomask 3 by a gasket 6. A vacuum pump 8 communicates with a space 7 which is defined between the cover film 5 and the photomask 3 to evacuate the space 7, thereby bringing the board 1 and the photomask 3 into close contact with each other. In this state, light 9 such as ultraviolet light, for example, is applied toward sthe photomask 3, to expose the photosensitive film 4 which is provided on the board 1.

In the exposure process shown in Fig. 5, the board 1 is positively retained in close contact with the photomask 3, to be subjected to exposure processing. Such a contact state of the board 1 and the photomask 3 is called a "hard contact" state.

In general, boards to be exposed through photomasks are superposed with the photomasks in the following three systems, including the aforementioned "hard contact" system:

(1) hard contact system of positively bringing the board into close contact with the photomask by vacuum absorption or the like;

(2) soft contact system of softly bringing the board into contact with the photomask; and

(3) off contact system of spacing the board and the photomask apart from each other.

Within these contact systems, the hard contact system of the item (1) is currently employed in most of exposure apparatuses for printed circuit boards. The remaining systems, particularly the off contact system of the item (3), are hardly employed.

The hard contact system is widely employed since the pattern provided on the photomask can be reproduced on the board in high fidelity. In other words, the hard contact system is excellent in resolution. It is easily imaginable that high resolution can also be attained by the soft contact system if the photomask and the board have completely flat surfaces. However, particularly the board is generally warped or irregularized in practice, and hence it is difficult to attain high resolution in the soft contact system.

Another reason for wide employment of the hard contact system is that non-collimation light is generally used as the light (ultraviolet light) for exposure processing. If a clearance is defined between the photomask and the board, therefore, the light reaches the back of the pattern, which is a non-translucent part of the photomask, to extremely reduce resolution.

In recent years, a circuit pattern formed on a board is increased in density to require high resolution in exposure processing. Therefore, collimation light is gradually increasingly employed for exposure processing in place of non-collimation light. Also in this case, exposure processing is still performed in the hard contact system.

In the case of the collimation light, it may be considered that sufficiently high resolution can be also attained by the off contact system in consideration of linearity of light. In practice, however, the pattern of the photomask cannot be reproduced on the board in high resolution due to other properties of light such as interference, diffraction, reflection, refraction and the like if a layer of air is interposed between the photomask and the board.

Even if the collimation light is used, therefore, the photomask and the board are superposed in the hard contact system to perform exposure processing under the present circumstances, in order to attain high resolution.

However, the hard contact system has various disadvantages as described below:

First, even when the photomask is brought into hard contact with the board by vacuum absorption or the like, air is inevitably partially left between the photomask and the board. Thus, it is difficult to bring the photomask and the board into close contact over the entire interface between the photomask and the board.

Second, extra time is required for performing vacuum absorption and operation for returning to the atmospheric pressure, to wastefully prolong the exposure step.

Third, when a photosensitive film (liquid photoresist material) is applied to the board, its surface is made so viscous that it is difficult to separate the photomask, which is brought into hard contact with the board, even if the board is slightly dried.

Fourth, if a foreign material such as dust sticks to the photomask or the board, this material is strongly adhered to the photomask and the board in the hard contact step to cause a significant defect.

Fifth, the photomask may be flawed in the hard contact step, to cause a defect.

Thus, the hard contact system has various disadvantages, and it is preferable to employ the off contact or soft contact system in order to avoid such disadvantages. However, the aforementioned problem of low resolution must be solved for employing the off contact or soft contact system.

SUMMARY OF THE INVENTION

Accordingly, an object of the present invention is to provide an exposure process which can perform exposure processing without reducing resolution even if the off contact or soft contact system is employed.

The present invention is basically directed to an exposure process of making a photomask in contact with or approach an object of exposure and applying light onto the object of exposure through the photomask thereby performing exposure processing on the object of exposure along a pattern which is drawn on the photomask, and in order to solve the aforementioned technical problem, a clearance defined between the photomask and the object of exposure is filled up with a liquid, for performing the exposure processing.

Preferably the present invention is carried out along the steps of:

(1) preparing a container of a translucent material having at least a flat bottom wall and being filled up with a liquid;

(2) fixing a photomask along the inner side of the bottom wall of the container;

(3) arranging an object of exposure above the photomask to be in contact with or approach the photomask; and

(4) applying light from below the bottom wall of the container thereby performing exposure processing on the object of exposure.

In place of the exposure process comprising the above steps, the present invention can be carried out along the steps of:

(1) preparing a container of a translucent material having at least one flat side wall and being filled up with a liquid;

(2) fixing a photomask along the inner side of the side wall of the container;

(3) arranging an object of exposure within the container to be in contact with or approach the lateral side of the photomask; and

(4) laterally applying light to the side wall from the exterior of the container to perform exposure processing on the object of exposure.

According to the present invention, the clearance between the photomask and the object of exposure may be filled up with the liquid by dipping the photomask and the object of exposure within the liquid, or by applying the liquid onto at least either the photomask or the object of exposure and making the photomask and the object of exposure approach each other while locating the liquid between the photomask and the object of exposure, thereby filling up the clearance between the photomask and the object of exposure with the liquid.

According to the present invention, further, the photomask can be arranged in relation to each of two major surfaces of the object of exposure, thereby to simultaneously perform exposure processing on both of the two major surfaces.

In the present invention, the clearance defined between the photomask and the object of exposure is filled up with the liquid, to perform exposure processing. When the clearance between the photomask and the object of exposure is filled up with air, which is extremely different in refractive index of light from other solids such as glass, plastic and the like, other properties of light such as interference, diffraction, reflection and the like are promoted to reduce resolution, as hereinabove described. If the clearance is filled up with a substance which is not substantially different in refractive index of light from the photomask and the photosensitive film which is applied to the object of exposure such as a board, for example, resolution is not much reduced as compared with the case of the hard contact system. In this case, the light used for exposure processing is preferably prepared from collimation light.

On the basis of such a view, a liquid such as water is employed in the present invention for filling up the clearance defined between the photomask and the object of exposure.

Thus, according to the present invention, the clearance between the photomask and the object of exposure is filled up with the liquid which is not substantially different in refractive index from the photomask and the object of exposure such as a photosensitive film, for example, and hence linearity of light is facilitated thereby reproducing the pattern of the photomask on the board in high fidelity.

Even if the clearance between the photomask and the object of exposure is irregular, the liquid can easily completely fill up the clearance without leaving a layer of air.

According to the present invention, the off contact or soft contact system can be employed with no problem, to attain the following advantages:

First, it is not necessary to strongly press the object of exposure against the photomask dissimilarly to the case of the hard contact system, whereby the time for such operation can be saved and no defect is caused by insufficient contact.

The photomask is not adhered to the photosensitive film which is applied to the object of exposure such as a board, for example, through stickiness of the photosensitive film.

The photomask is not flawed since exposure processing can be performed in the soft contact or off contact system.

Foreign materials contained in the air are prevented by the liquid from entering the clearance between the photomask and the object of exposure, while those mixed into the liquid with the object of exposure can be easily removed by providing a filter for the liquid.

The liquid filling up the clearance between the photomask and the object of exposure facilitates temperature control of the photomask and the object of exposure. It is desirable to strictly control temperature conditions for the photomask and the object of exposure, since the temperature conditions exert influence on the exposure processing. For example, the temperatures of the photomask and the object of exposure are increased by application of light, while such temperature rise can be prevented by the liquid.

Thus, according to the present invention, exposure processing can be performed in higher reliability and productivity as compared with the conventional exposure process employing the hard contact system.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a sectional view showing a state of carrying out an embodiment of the present invention;

Fig. 2 is a sectional view showing a state of carrying out another embodiment of the present invention;

Fig. 3 is a sectional view showing a state of carrying out still another embodiment of the present invention;

Fig. 4 is a sectional view for illustrating a further embodiment of the present invention; and

Fig. 5 is a sectional view showing a state of carrying out a conventional exposure process.

DESCRIPTION OF THE PREFERRED EMBODIMENTS

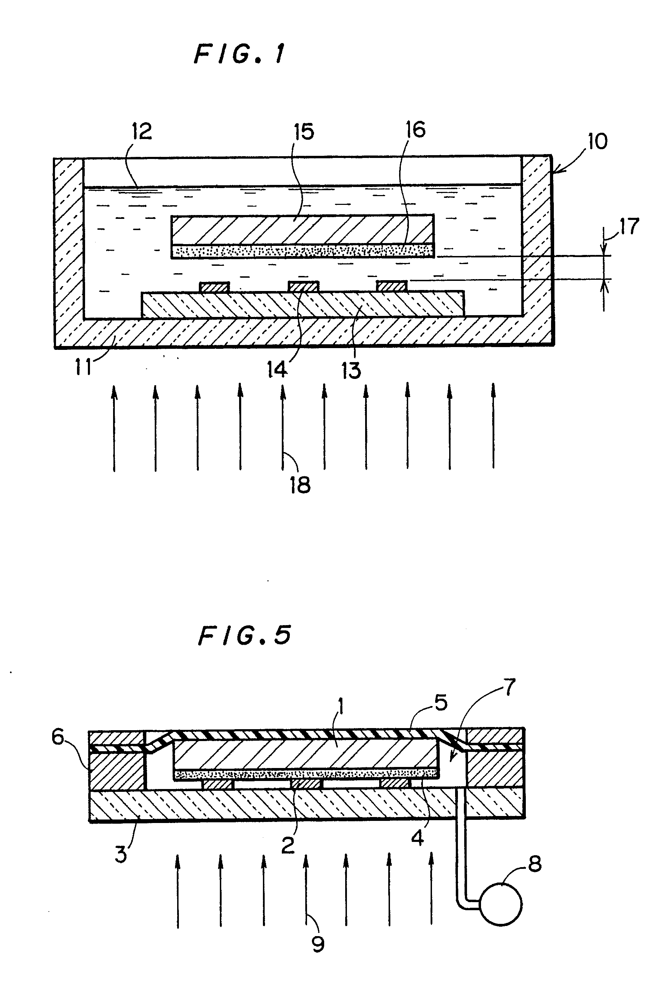

Fig. 1 shows a state of carrying out an embodiment of the present invention.

As shown in Fig. 1, a container 10 made of a translucent material is prepared in this embodiment. This container 10 is flattened at least in its bottom wall 11, and filled up with a liquid 12 such as water, for example.

A photomask 13 is fixed along the inner side of the bottom wall 11 of the container 10. This photomask 13 is previously provided with a pattern 14.

A printed circuit board 15, which is an object of exposure, is arranged above the photomask 13 to leave no air between the photomask 13 and the board 15. A photosensitive film 16 is previously applied to the board 15 by adhering a photosensitive dry film or applying a paste material for forming the photosensitive film 16 to the board 15, as is well known in the art. The board 15 is so arranged that the photosensitive film 16 faces the photomask 13.

Thus, the board 15 is located in the container 10 with a clearance 17 defined between the same and the photomask 13. This clearance 17, which is filled up with the liquid 12, is preferably reduced to the minimum. If the board 15 is warped or irregularized, it is preferable to hold the board 15 by other means (not shown) thereby softly pressing the same against the photomask 13 over its entire surface.

In the state shown in Fig. 1, light 18 is applied from below the bottom wall 11 of the container 10 to perform exposure processing. The light 18 is preferably prepared from collimation light. This light 18 reaches the photosensitive film 16 provided on the board 15 through the bottom wall 11, the photomask 13 and the liquid 12, to expose photosensitive film 16 along the pattern 14 which is drawn on the photomask 13.

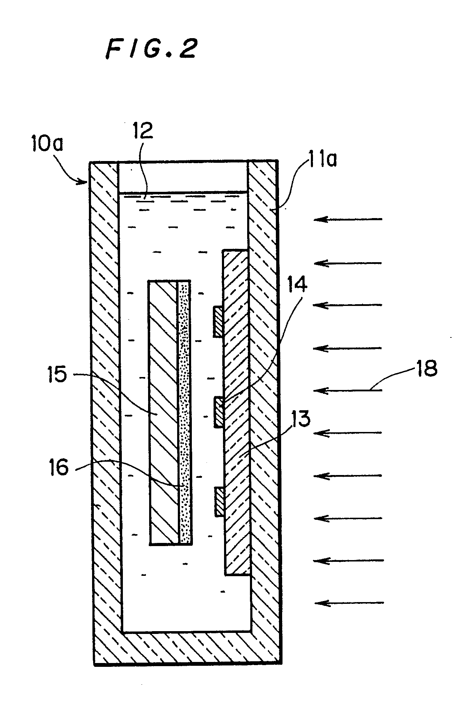

Fig. 2 shows a state of carrying out another embodiment of the present invention.

In the embodiment shown in Fig. 2, a container 10a made of a translucent material is flattened at least in one side wall 11a. This container 10a is filled up with a liquid 12, similarly to the aforementioned embodiment.

A photomask 13 provided with a pattern 14 is fixed along the inner side of the side wall 11a of the container 10a.

A printed circuit board 15, which is an object of exposure, is arranged within the container 10a on the lateral side of the side wall 11a. A photosensitive film 16 is previously applied to the board 15, similarly to the aforementioned embodiment.

Light 18 is laterally applied toward the side wall 11a from the exterior of the container 10a. This light 18 exposes the photosensitive film 16 which is provided on the board 15.

According to the embodiment shown in Fig. 2, the photomask 13 and the board 15 are vertically held so as to further reduce possibility of leaving air bubbles between the photomask 13 and the board 15 as compared with the embodiment shown in Fig. 1. In this point, it can be said that the exposure process shown in Fig. 2 is superior to that shown in Fig. 1.

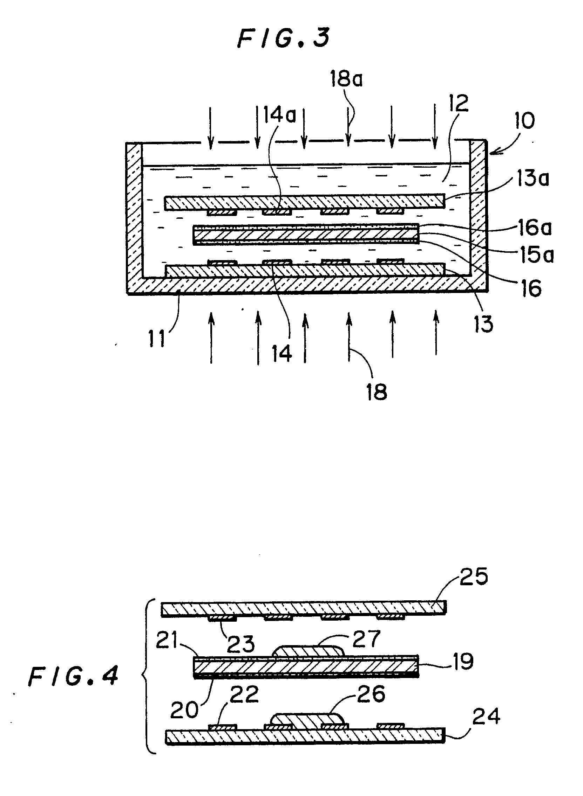

Fig. 3 shows a state of carrying out still another embodiment of the present invention.

The embodiment shown in Fig. 3 is similar to the embodiment shown in Fig. 1. Therefore, corresponding parts are indicated by the same reference numerals, to omit redundant description.

In the embodiment shown in Fig. 3, a board 15a has an opposite pair of major surfaces to be exposed. Thus, photosensitive films 16 and 16a are previously applied to the respective major surfaces of the board 15a respectively.

A photomask 13 which is arranged along the inner side of a bottom wall 11 of a container 10 faces the first photosensitive film 16 which is provided on the board 15a. In addition to the photomask 13, another photomask 13a, which is previously provided with a pattern 14a, is arranged to face the second photosensitive film 16 provided on the board 15a. The photomask 13a is also located in a liquid 12.

In order to perform exposure processing, light 18 is applied from below the bottom wall 11 of the container 10, while another light 18a is applied from above the liquid 12. Thus, the photosensitive films 16 and 16a applied to the respective major surfaced of the board 15a are simultaneously exposed. A transparent plate (not shown) may be arranged to be in contact with the surface of the liquid 12 so that the light 18a applied from above is not disturbed by waving of the liquid surface.

Fig. 4 is a diagram for illustrating a further embodiment of the present invention.

The feature of the embodiment shown in Fig. 4 resides in a method of filling up a clearance between a photomask and a object of exposure with a liquid. Further, this embodiment is adapted to expose both surfaces of a board 19, which is the object of exposure. Thus, photosensitive films 20 and 21 are previously applied to the two major surfaces of the board 19 respectively. Further, patterns 22 and 23 are previously formed on first and second photomasks 24 and 25 respectively.

First, a liquid 26 is dripped on a central portion of the upper surface of first photomask 24. Then, the photomask 24 and the board 19 are made to approach each other, so that the liquid 26 spreads over a clearance between the photomask 24 and the board 19 to discharge air from the clearance, thereby filling up the clearance. The liquid 26 dripped on the photomask 24 as described above may have a volume sufficient for filling up the clearance between the photomask 24 and the board 19.

Then, another liquid 27 is dripped on a central portion of the upper surface of the board 19. Thereafter the second photomask 25 is made to approach the board 19. The liquid 27 responsively spreads over a clearance between the photomask 25 and the board 19, to fill up the clearance.

Then, rays of light (not shown) are applied from below the first photomask 24 and from above the second photomask 25 respectively. Thus, the two surfaces of the board 19 are simultaneously exposed.

In order to expose the both surfaces of the board 19, the rays of light may be separately applied to the surfaces with no simultaneous application.

While the both surfaces of the board 19 are exposed in the embodiment shown in Fig. 4, the method of filling up the clearance with the liquid as shown in Fig. 4 is also applicable to the case of exposing only one surface of a board.

The liquids 26 and 27, which are applied to the central portions of the photomask 24 and the board 19 in the embodiment shown in Fig. 4, may be dripped on end portions respectively. Alternatively, the liquids may be applied to overall surfaces or substantially overall surfaces of the photomask and the board. In this case, the liquid(s) may be applied to the photomask and/or the board with a brush or roller, or the photomask and/or the board may be dipped in the liquid(s). Or, clearances to be filled up with liquids may be previously defined between the photomasks and the board, to thereafter introduce the liquids into the clearances. In this case, pressure difference may be caused between the inside and outside of the clearances for facilitating introduction of the liquids into the clearances, if necessary.

The embodiment shown in Fig. 4 requires no container for containing the liquids, whereby the inventive exposure process can be carried out at a low cost in view of equipment.

While the present invention has been described with reference to the embodiments shown in the accompanying drawings, further modifications are available within the scope of the present invention.

For example, although a printed circuit board is employed as an object of exposure in each embodiment, the present invention can also be applied to a board other than the printed circuit board. For example, the present invention is also applicable to exposure processing which is required for fabrication of a semiconductor wafer, a plate type display board such as a liquid crystal display, or the like.

In addition to water, the liquid for filling up the clearance between the photomask and the object of exposure may be prepared from any liquid so far as the same exerts no bad influence on the photosensitive material etc.

While the light source (not shown) for emitting the light 18 or 18a is provided on the exterior of the container 10 or 10a in each of the embodiments shown in Figs. 1, 2 and 3, such a light source may be arranged in the container, i.e., within the liquid.

The bottom wall 11 in the embodiment shown in Fig. 1 or 3, or the side wall 11a in the embodiment shown in Fig. 2 itself may serve as a photomask. In this case, the bottom wall 11 or the side wall 11a serving as a photomask may be detachably mounted on the remaining part of the container 10 or 10a, so that the photomask is replaceable.

Although the present invention has been described and illustrated in detail, it is clearly understood that the same is by way of illustration and example only and is not to be taken by way of limitation, the scope of the present invention being limited only by the terms of the appended claims.

## Claims

1. An exposure process of making a photomask and an object of exposure in contact with or approach each other and applying light onto said object of exposure through said photomask thereby performing exposure processing on said object of exposure along a pattern drawn on said photomask, said process including a step of filling up a clearance between said photomask and said object of exposure with a liquid for performing said exposure processing.

2. An exposure process in accordance with claim 1, wherein said step of filling up a clearance between said photomask and said object of exposure with a liquid includes a step of dipping said photomask and said object of exposure in said liquid.

3. An exposure process in accordance with claim 1, wherein said step of filling up a clearance between said photomask and said object of exposure with a liquid includes a step of applying said liquid onto at least either said photomask or said object of exposure and a step of making said photomask and said object of exposure approach each other while locating said liquid between said photomask and said object of exposure thereby filling up said clearance between said photomask and said object of exposure with said liquid.

4. An exposure process in accordance with claim 1, wherein said object of exposure has an opposite pair of major surfaces to be exposed and said photomask is arranged in relation to each of said major surfaces of said object of exposure, said exposure processing being simultaneously performed on both of said pair of major surfaces.

5. An exposure process comprising the steps of:
preparing a container of a translucent material having at least a flat bottom wall and being filled up with a liquid;
fixing a photomask along the inner side of said bottom wall of said container;
arranging an object of exposure above said photomask to be in contact with or approach said photomask; and
applying light from below said bottom wall of said container to perform exposure processing on said object of exposure.

6. An exposure process in accordance with claim 5, wherein said object of exposure has an opposite pair of major surfaces to be exposed and said step of arranging said object of exposure above said photomask includes a step of arranging one of said major surfaces to face said photomask, said exposure process further including a step of arranging a second photomask within said liquid to be in contact with or approach the other said major surface and a step of applying light from above said second photomask for performing exposure processing on said other major surface of said object of exposure.

7. An exposure process comprising the steps of:
preparing a container of a translucent material having at least a flat side wall and being filled up with a liquid;
fixing a photomask along the inner side of said side wall of said container;
arranging an object of exposure within said container to be in contact with or approach the lateral side of said photomask; and
laterally applying light toward said side wall from the exterior of said container for performing exposure processing on said object of exposure.

8. An exposure process in accordance with claim 1, wherein water is employed as said liquid.

9. An exposure process in accordance with claim 1, wherein said object of exposure is a board for serving as a printed circuit board.

10. An exposure process in accordance with claim 1, wherein said light applied in said exposure processing is collimation light.

## FIG. 1

## FIG. 5

# *FIG.2*

## FIG.3

## FIG.4